(19)

**Europäisches Patentamt**
**European Patent Office**
**Office européen des brevets**

(11)  **EP 4 780 143 A1**

(12)  **EUROPEAN PATENT APPLICATION**
published in accordance with Art. 153(4) EPC

(43) Date of publication:
**22.07.2026 Bulletin 2026/30**

(21) Application number: **24888707.7**

(22) Date of filing: **05.11.2024**

(51) International Patent Classification (IPC):
***H05H 1/46*** (2006.01)

(52) Cooperative Patent Classification (CPC):
**H05H 1/46**

(86) International application number:
**PCT/JP2024/039311**

(87) International publication number:
**WO 2025/100412 (15.05.2025 Gazette 2025/20)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **10.11.2023 JP 2023192179**

(71) Applicant: **Tokyo Electron Limited**
**Tokyo 107-6325 (JP)**

(72) Inventors:
• **KOSAKA Yuto**
  **Kurokawa-gun, Miyagi 981-3629 (JP)**
• **KOSHIMIZU Chishio**
  **Kurokawa-gun, Miyagi 981-3629 (JP)**

(74) Representative: **Hoffmann Eitle**
**Patent- und Rechtsanwälte PartmbB**
**Arabellastraße 30**
**81925 München (DE)**

(54)  **PLASMA PROCESSING DEVICE, POWER SUPPLY SYSTEM, AND CONTROL METHOD**

(57)  A disclosed power supply system of a plasma processing apparatus includes a radio frequency power supply, a bias power supply, and a power supply controller. The radio frequency power supply generates radio frequency power for plasma generation. The bias power supply supplies an electric bias to a substrate support. The power supply controller periodically modulates a power level of the radio frequency power in repetitions of a modulation cycle including at least two sub-periods. The power supply controller is configured to adjust a frequency of the radio frequency power for an n-th phase period included in a feedback period continuing from a start time of each of the at least two sub-periods within the modulation cycle, based on a change in the frequency of the radio frequency power and a change in a degree of reflection of the radio frequency power in the n-th phase period in preceding repetitions of the modulation cycle.

Fig.2

## Description

### Technical Field

Example embodiments of the present disclosure relate to a plasma processing apparatus, a power supply system, and a control method.

### Background Art

A plasma processing apparatus is used in plasma processing of a substrate. In the plasma processing apparatus, bias radio frequency power is used to attract ions from plasma generated in a chamber to a substrate. Patent Literature 1 below discloses a plasma processing apparatus that modulates the power level and frequency of bias radio frequency power.

### Citation List

### Patent Literature

[Patent Literature 1] Japanese Unexamined Patent Publication No. 2009-246091

### Summary of Invention

### Technical Problem

The present disclosure provides a technique for suppressing reflection of radio frequency power.

### Solution to Problem

In one example embodiment, a plasma processing apparatus is provided. The plasma processing apparatus includes a chamber, a substrate support, and a power supply system. The substrate support is disposed in the chamber. The power supply system includes a radio frequency power supply, a bias power supply, and a power supply controller. The radio frequency power supply is configured to supply radio frequency power to generate plasma in the chamber of the plasma processing apparatus. The bias power supply is configured to supply an electric bias to the substrate support repeatedly at a time interval of a waveform cycle to attract ions from the plasma to a substrate on the substrate support disposed in the chamber. The power supply controller is configured to periodically modulate a power level of the radio frequency power in repetitions of a modulation cycle. The modulation cycle includes a plurality of sub-periods. The plurality of sub-periods includes at least two sub-periods in which respective power levels of the radio frequency power are set to levels greater than zero and different from each other. Each of the at least two sub-periods includes a feedback period continuing from a start time thereof. The power supply controller is configured to adjust a frequency of the radio frequency power for an n-th phase period included in the feedback period within the modulation cycle, based on a change in the frequency of the radio frequency power and a change in a degree of reflection of the radio frequency power in the n-th phase period in preceding repetitions of the modulation cycle, so as to suppress the degree of reflection of the radio frequency power.

### Advantageous Effects of Invention

According to one example embodiment, reflection of radio frequency power may be suppressed.

### Brief Description of Drawings

FIG. 1 is a diagram for explaining a configuration example of a plasma processing system.
FIG. 2 is a diagram for explaining a configuration example of a capacitively coupled plasma processing apparatus.
FIG. 3 is a diagram illustrating an example of a waveform of an electric bias.
FIG. 4 is an example timing chart related to a power supply system according to one example embodiment.
FIG. 5 is an example timing chart related to a power supply system according to one example embodiment.
FIG. 6 is an example timing chart related to a power supply system according to one example embodiment.

FIG. 7 is an example timing chart related to a power supply system according to one example embodiment.

FIG. 8 is an example timing chart related to a power supply system according to one example embodiment.

FIG. 9 is an example timing chart related to a power supply system according to one example embodiment.

FIG. 10 is an example timing chart related to a power supply system according to one example embodiment.

FIG. 11 is an example timing chart related to a power supply system according to one example embodiment.

FIG. 12 is an example timing chart related to a power supply system according to one example embodiment.

FIG. 13 is an example timing chart related to a power supply system according to one example embodiment.

FIG. 14 is an example timing chart related to a power supply system according to one example embodiment.

FIG. 15 is an example timing chart related to a power supply system according to one example embodiment.

FIG. 16 is an example timing chart related to a power supply system according to one example embodiment.

FIG. 17 is an example timing chart related to a power supply system according to one example embodiment.

FIG. 18(a) is a flowchart of a control method according to one example embodiment, and FIG. 18(b) is a flowchart of step STa illustrated in FIG. 18(a).

FIG. 19 is a flowchart illustrating an example of processing in step STd illustrated in FIG. 18(b).

FIG. 20 is a flowchart illustrating an example of processing in step ST7 illustrated in FIG. 19.

FIG. 21 is a flowchart illustrating another example of processing in step STd illustrated in FIG. 18(b).

FIG. 22 is a flowchart illustrating an example of processing in step ST7a illustrated in FIG. 21.

FIG. 23 is a timing chart related to a power supply system according to one example embodiment.

**Description of Embodiments**

Hereinafter, various example embodiments will be described in detail with reference to the drawings. In the drawings, the same or equivalent portions are denoted by the same reference signs.

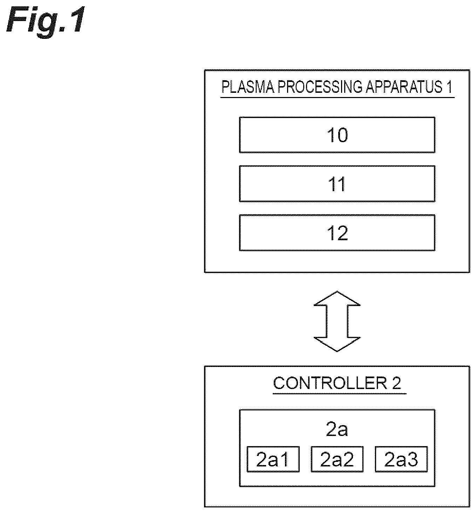

FIG. 1 illustrates an example configuration of a plasma processing system. In an embodiment, the plasma processing system includes a plasma processing apparatus 1 and a controller 2. The plasma processing system is an example of a substrate processing system, and the plasma processing apparatus 1 is an example of a substrate processing apparatus. The plasma processing apparatus 1 includes a plasma processing chamber 10, a substrate support 11, and a plasma generator 12. The plasma processing chamber 10 has a plasma processing space. The plasma processing chamber 10 further has at least one gas inlet for supplying at least one process gas into the plasma processing space and at least one gas outlet for exhausting gases from the plasma processing space. The gas inlet is connected to a gas supply 20 described below and the gas outlet is connected to a gas exhaust system 40 described below. The substrate support 11 is disposed in the plasma processing space and has a substrate supporting surface for supporting a substrate.

The plasma generator 12 is configured to generate a plasma from the at least one process gas supplied into the plasma processing space. The plasma formed in the plasma processing space may be, for example, a capacitively coupled plasma (CCP), an inductively coupled plasma (ICP), an electron-cyclotron-resonance (ECR) plasma, a helicon wave plasma (HWP), or a surface wave plasma (SWP).

The controller 2 processes computer executable instructions causing the plasma processing apparatus 1 to perform various steps described in this disclosure. The controller 2 may be configured to control individual components of the plasma processing apparatus 1 such that these components execute the various steps. In an embodiment, the controller 2 may be partially or entirely incorporated into the plasma processing apparatus 1. The controller 2 may include a processor 2a1, a storage 2a2, and a communication interface 2a3. The controller 2 is implemented in, for example, a computer 2a. The processor 2a1 may be configured to read a program from the storage 2a2, and then perform various controlling operations by executing the program. This program may be preliminarily stored in the storage 2a2 or retrieved from any medium, as appropriate. The resulting program is stored in the storage 2a2, and then the processor 2a1 reads the program from the storage 2a2 to execute the program. The medium may be of any type which can be accessed by the computer 2a or may be a communication line connected to the communication interface 2a3. The processor 2a1 may be a programmable logic device such as a central processing unit (CPU) or a field-programmable gate array (FPGA). The storage 2a2 may include a random access memory (RAM), a read only memory (ROM), a hard disk drive (HDD), a solid state drive (SSD), or any combination thereof. The communication interface 2a3 can communicate with the plasma processing apparatus 1 via a communication line, such as a local area network (LAN).

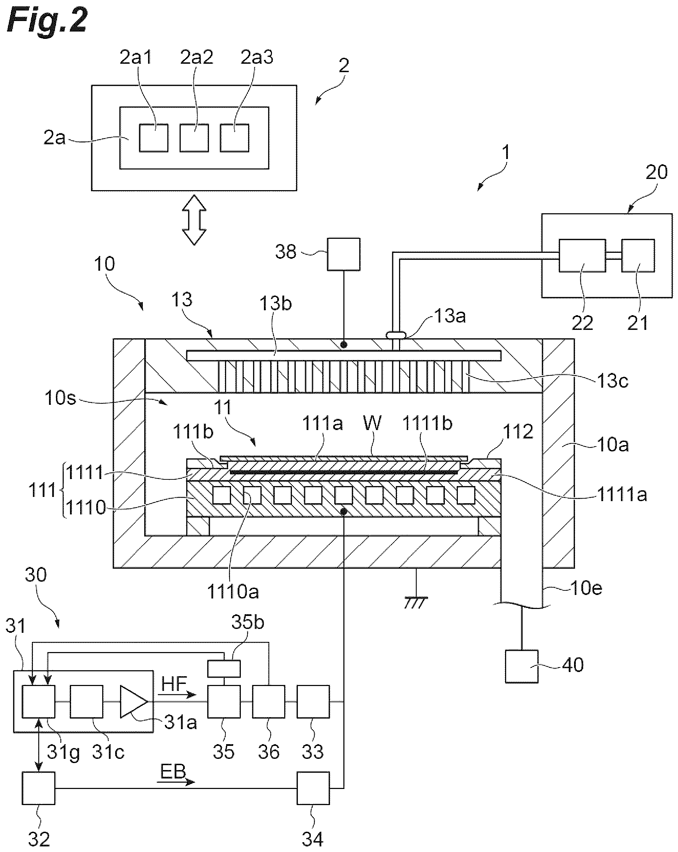

An example configuration of a capacitively coupled plasma processing apparatus, which is an example of the plasma processing apparatus 1, will now be described. FIG. 2 illustrates the example configuration of the capacitively coupled plasma processing apparatus.

The capacitively coupled plasma processing apparatus 1 includes a plasma processing chamber 10, a gas supply 20, a power supply system 30, and a gas exhaust system 40. The plasma processing apparatus 1 further includes a substrate support 11 and a gas introduction unit. The gas introduction unit is configured to introduce at least one process gas into the plasma processing chamber 10. The gas introduction unit includes a showerhead 13. The substrate support 11 is disposed in the plasma processing chamber 10. The showerhead 13 is disposed above the substrate support 11. In an embodiment, the showerhead 13 forms at least part of the ceiling of the plasma processing chamber 10. The plasma processing chamber 10 has a plasma processing space 10s that is defined by the showerhead 13, the sidewall 10a of the plasma processing chamber 10, and the substrate support 11. The plasma processing chamber 10 is grounded. The substrate support 11 is electrically insulated from the housing of the plasma processing chamber 10.

The substrate support 11 includes a body 111 and a ring assembly 112. The body 111 has a central region 111a for supporting a substrate W and an annular region 111b for supporting the ring assembly 112. An example of the substrate W is a wafer. The annular region 111b of the body 111 surrounds the central region 111a of the body 111 in plan view. The substrate W is disposed on the central region 111a of the body 111, and the ring assembly 112 is disposed on the annular region 111b of the body 111 so as to surround the substrate W on the central region 111a of the body 111. Thus, the central region 111a is also called a substrate supporting surface for supporting the substrate W, while the annular region 111b is also called a ring supporting surface for supporting the ring assembly 112.

In an embodiment, the body 111 includes a base 1110 and an electrostatic chuck 1111. The base 1110 includes a conductive member. The electrostatic chuck 1111 is disposed on the base 1110. The electrostatic chuck 1111 includes a ceramic member 1111a and an electrostatic electrode 1111b disposed in the ceramic member 1111a. The ceramic member 1111a has the central region 111a. In an embodiment, the ceramic member 1111a also has the annular region 111b. Any other member, such as an annular electrostatic chuck or an annular insulating member, surrounding the electrostatic chuck 1111 may have the annular region 111b. In this case, the ring assembly 112 may be disposed on either the annular electrostatic chuck or the annular insulating member, or both the electrostatic chuck 1111 and the annular insulating member.

The ring assembly 112 includes one or more annular members. In an embodiment, the annular members include one or more edge rings and at least one cover ring. The edge ring is composed of a conductive or insulating material, whereas the cover ring is composed of an insulating material.

The substrate support 11 may also include a temperature adjusting module that is configured to adjust at least one of the electrostatic chuck 1111, the ring assembly 112, and the substrate to a target temperature. The temperature adjusting module may be a heater, a heat transfer medium, a flow passage 1110a, or any combination thereof. A heat transfer fluid, such as brine or gas, flows through the flow passage 1110a. In an embodiment, the flow passage 1110a is formed in the base 1110, and one or more heaters are disposed in the ceramic member 1111a of the electrostatic chuck 1111. The substrate support 11 may further include a heat transfer gas supply configured to supply a heat transfer gas to a gap between the rear surface of the substrate W and the central region 111a.

The showerhead 13 is configured to introduce at least one process gas from the gas supply 20 into the plasma processing space 10s. The showerhead 13 has at least one gas inlet 13a, at least one gas diffusing space 13b, and a plurality of gas feeding ports 13c. The process gas supplied to the gas inlet 13a passes through the gas diffusing space 13b and is then introduced into the plasma processing space 10s from the gas feeding ports 13c. The showerhead 13 further includes at least one upper electrode. The gas introduction unit may include one or more side gas injectors (SGIs) provided at one or more openings formed in the sidewall 10a, in addition to the showerhead 13.

The gas supply 20 may include at least one gas source 21 and at least one flow controller 22. In an embodiment, the gas supply 20 is configured to supply at least one process gas from the corresponding gas source 21 through the corresponding flow controller 22 into the showerhead 13. Each flow controller 22 may be, for example, a mass flow controller or a pressure-controlled flow controller. The gas supply 20 may include at least one flow modulation device that can modulate or pulse the flow of the at least one process gas.

The gas exhaust system 40 may be connected to, for example, a gas outlet 10e provided in the bottom wall of the plasma processing chamber 10. The gas exhaust system 40 may include a pressure regulation valve and a vacuum pump. The pressure regulation valve enables the pressure in the plasma processing space 10s to be adjusted. The vacuum pump may be a turbo-molecular pump, a dry pump, or a combination thereof.

The power supply system 30 includes a radio frequency power supply 31 and a bias power supply 32. The power supply system 30 may further include a DC power supply 38. The radio frequency power supply 31 configures the plasma generator 12 of one embodiment. The radio frequency power supply 31 is configured to generate radio frequency power. In the following description, the radio frequency power generated by the radio frequency power supply 31 is referred to as source radio frequency power HF. The source radio frequency power HF has a frequency. In the following description, the frequency of the source radio frequency power HF is referred to as a source frequency. The source radio frequency power HF has a sinusoidal waveform of which a frequency is the source frequency. The source frequency may be a frequency in the range of 10 MHz to 150 MHz.

The radio frequency power supply 31 is electrically connected to a radio frequency electrode via a matching unit 33, and is configured to supply the source radio frequency power HF to the radio frequency electrode. The radio frequency electrode may be disposed in the substrate support 11. The radio frequency electrode may be the conductive member of the base 1110 or at least one electrode disposed in the ceramic member 1111a. Alternatively, the radio frequency electrode may be an upper electrode. When the source radio frequency power HF is supplied to the radio frequency electrode, plasma is generated from the gas in the chamber 10.

The matching unit 33 has a variable impedance. The variable impedance of the matching unit 33 is set so as to reduce reflection of the source radio frequency power HF from the load. The matching unit 33 may be controlled by, for example, the controller 2.

In one embodiment, the radio frequency power supply 31 may include a signal generator 31g, a D/A converter 31c, and an amplifier 31a. The signal generator 31g generates a radio frequency signal having a source frequency f. The signal generator 31g may be configured with a programmable processor or a programmable logic device such as an FPGA (Field-Programmable Gate Array).

The output of the signal generator 31g is connected to the input of the D/A converter 31c. The D/A converter 31c converts the radio frequency signal from the signal generator 31g into an analog signal. The output of the D/A converter 31c is connected to the input of the amplifier 31a. The amplifier 31a amplifies the analog signal from the D/A converter 31c to generate the source radio frequency power HF. The amplification factor of the amplifier 31a is specified by the controller 2 to the radio frequency power supply 31. The radio frequency power supply 31 may not include the D/A converter 31c. In this case, the output of the signal generator 31g is connected to the input of the amplifier 31a, and the amplifier 31a amplifies the radio frequency signal from the signal generator 31g to generate the source radio frequency power HF.

The bias power supply 32 is electrically coupled to the substrate support 11. The bias power supply 32 is electrically connected to a bias electrode in the substrate support 11, and is configured to supply an electric bias EB to the bias electrode. The bias electrode may be the conductive member of the base 1110 or at least one electrode disposed in the ceramic member 1111a. The bias electrode may be shared with the radio frequency electrode. When the electric bias EB is supplied to the bias electrode, ions from the plasma are attracted to the substrate W.

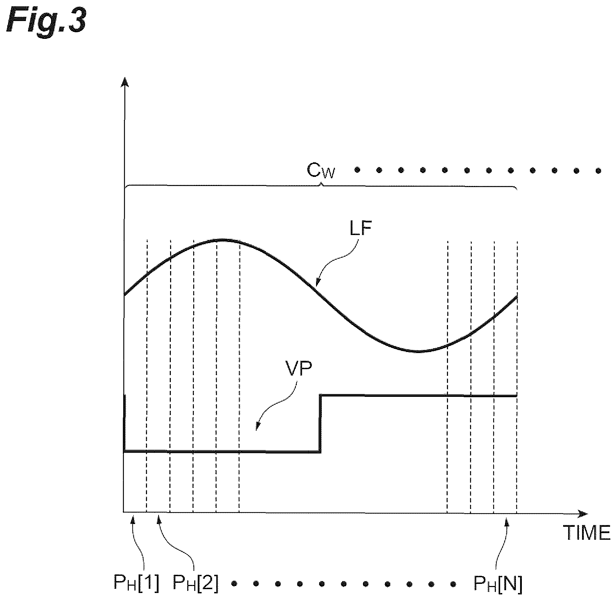

Hereinafter, reference is made to FIG. 3 together with FIG. 2. FIG. 3 is a diagram illustrating an example of a waveform of an electric bias. The bias power supply 32 is configured to periodically apply an electric bias EB having a waveform cycle $C_W$ to the bias electrode. That is, the electric bias EB is applied to the bias electrode in each of a plurality of waveform cycles $C_W$ that are repetitions of the waveform cycle $C_W$. The waveform cycle $C_W$ is defined by a bias frequency $f_{EB}$. The bias frequency $f_{EB}$ is, for example, a frequency of 50 kHz or more and 27 MHz or less. The time length of the waveform cycle $C_W$ is the reciprocal of the bias frequency.

The electric bias EB may be a bias radio frequency power LF having a bias frequency. That is, the electric bias EB may have a sinusoidal waveform of which a frequency is the bias frequency. In this case, the bias power supply 32 is electrically connected to the bias electrode via a matching unit 34. The variable impedance of the matching unit 34 is set so as to reduce reflection of the bias radio frequency power LF from the load.

Alternatively, the electric bias EB may include a voltage pulse VP. The voltage pulse VP is applied to the bias electrode within the waveform cycle $C_W$. The voltage pulse VP is periodically applied to the bias electrode at a time interval equal to the time length of the waveform cycle $C_W$. The waveform of the voltage pulse VP may be a rectangular wave, a triangular wave, or any waveform. The polarity of the voltage of the voltage pulse VP is set so as to create a potential difference between the substrate W and the plasma to attract ions from the plasma to the substrate W. The voltage pulse VP is applied to the bias electrode such that the waveform cycle $C_W$ includes a period during which the potential of the substrate W is a negative potential. The voltage pulse VP applied to the bias electrode may have a negative potential, may have a positive potential, or may have a potential that varies between a positive potential and a negative potential. The voltage pulse VP may be a pulse of a negative voltage or a pulse of a negative DC voltage. When the electric bias EB is the voltage pulse VP, the plasma processing apparatus 1 may not include the matching unit 34.

As illustrated in FIG. 2, the plasma processing apparatus 1 may further include a sensor 35 and/or a sensor 36. The sensor 35 is configured to measure a power level Pr of a reflected wave of the source radio frequency power HF from the load. The sensor 35 includes, for example, a directional coupler. The directional coupler may be disposed between the radio frequency power supply 31 and the matching unit 33. The sensor 35 may further be configured to measure a power level Pf of a traveling wave of the source radio frequency power HF. The power level Pr of the reflected wave measured by the sensor 35 is notified to the radio frequency power supply 31. In addition, the power level Pf of the traveling wave may be notified from the sensor 35 to the radio frequency power supply 31. The sensor 35 may notify the radio frequency power supply 31 of the reflectance, i.e., Pr/Pf. The reflectance may be determined in the radio frequency power supply 31 from the power level Pf and the power level Pr. A detection circuit 35b may be connected between the sensor 35 and the radio frequency power supply 31, and the power level Pf and the power level Pr may be determined from the output of the detection circuit 35b.

The sensor 36 includes a voltage sensor and a current sensor. The sensor 36 is configured to measure a voltage $V_S$ and a current $I_S$ in a feed path connecting the radio frequency power supply 31 and the radio frequency electrode to each other. The source radio frequency power HF is supplied to the radio frequency electrode via this feed path. The sensor 36 may be disposed between the radio frequency power supply 31 and the matching unit 33. The voltage $V_S$ and the current $I_S$ are notified to the radio frequency power supply 31. The sensor 36 may notify the radio frequency power supply 31 of an impedance $Z_L$ of the load of the radio frequency power supply 31 determined from the voltage $V_S$ and the current $I_S$. The impedance $Z_L$ may be determined in the radio frequency power supply 31 from the voltage $V_S$ and the current $I_S$. The sensor 36 may notify the radio frequency power supply 31 of a phase difference θ between the voltage $V_S$ and the current

$I_S$. The phase difference $\theta$ may be determined in the radio frequency power supply 31 from the voltage $V_S$ and the current $I_S$. The sensor 36 may notify the radio frequency power supply 31 of a reflection coefficient $\Gamma$ determined from the voltage $V_S$ and the current $I_S$. The reflection coefficient $\Gamma$ may be determined in the radio frequency power supply 31 from the voltage $V_S$ and the current $I_S$.

The DC power supply 38 is configured to apply a DC voltage DCS to the upper electrode. The DC power supply 38 may apply a negative DC voltage to the upper electrode. The DC power supply 38 may be a variable DC power supply.

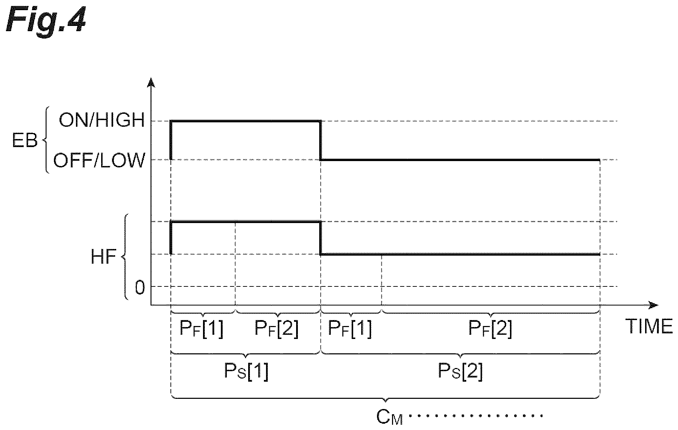

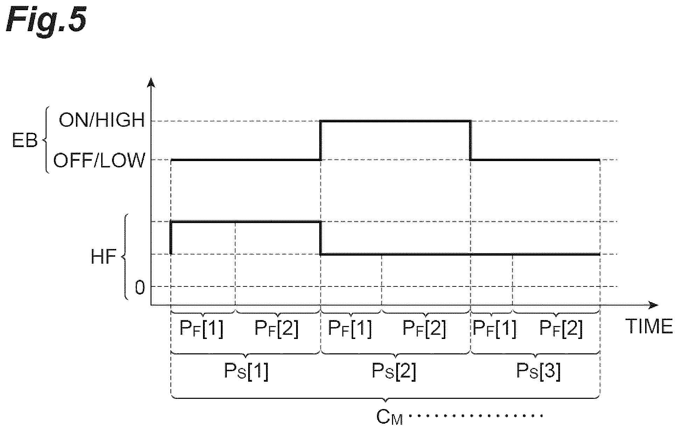

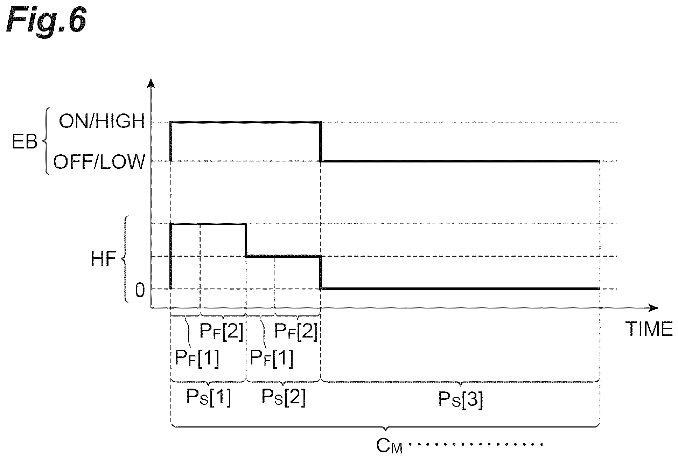

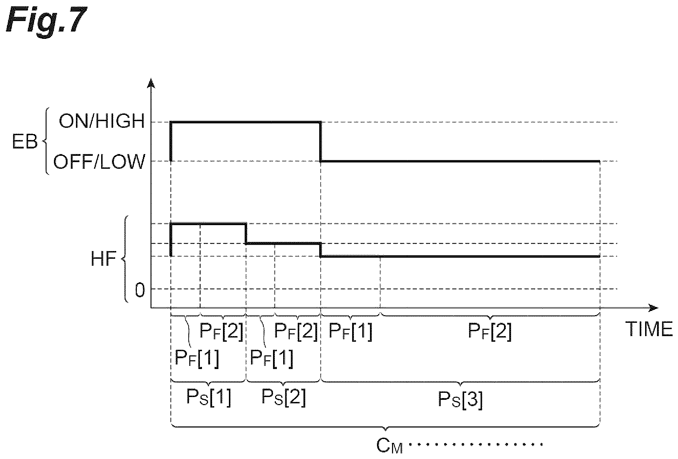

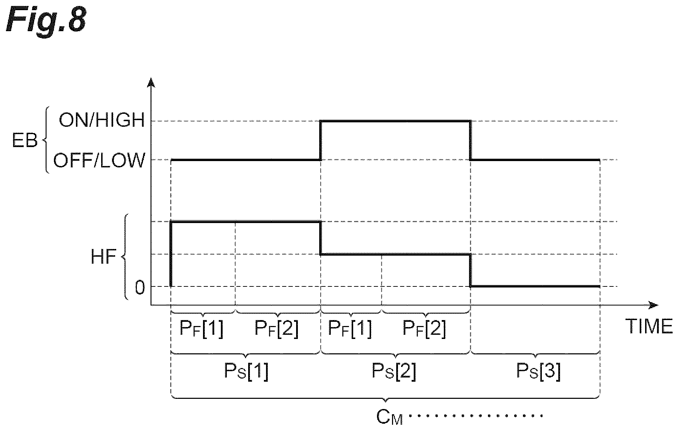

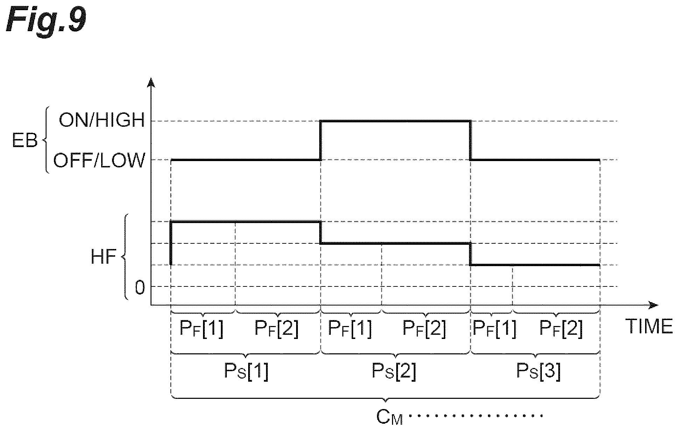

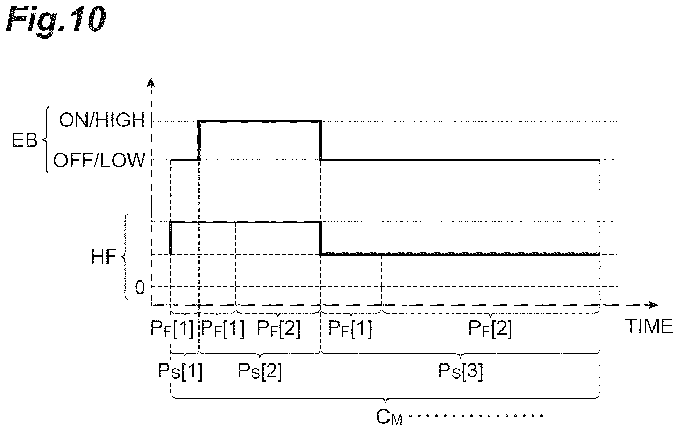

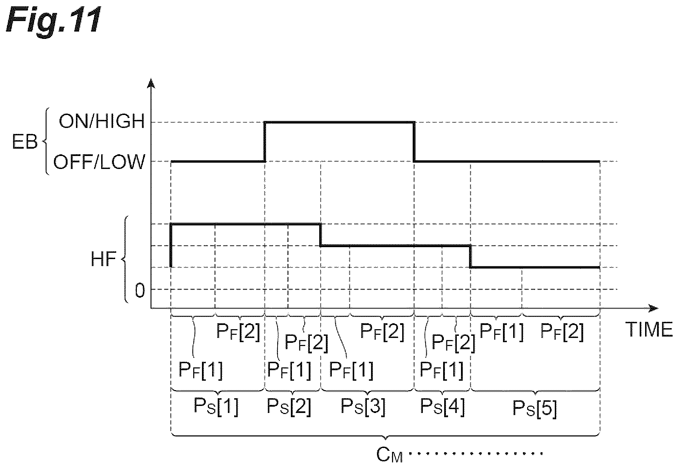

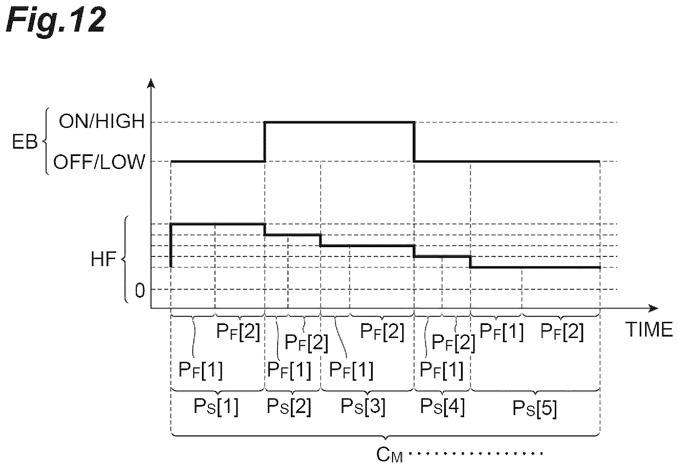

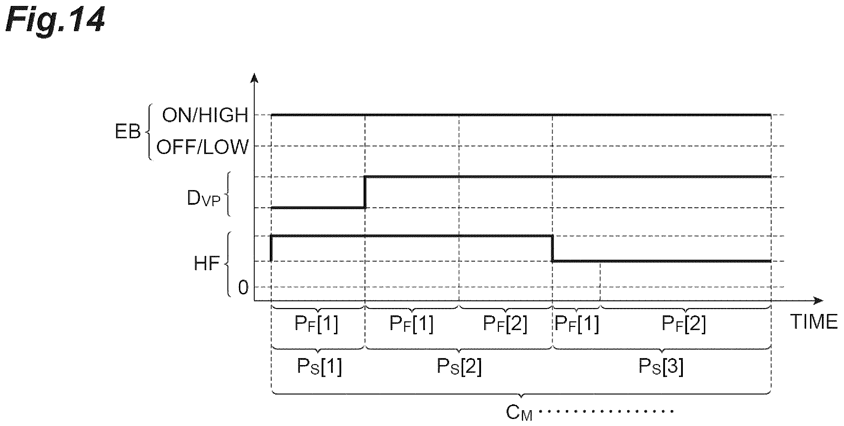

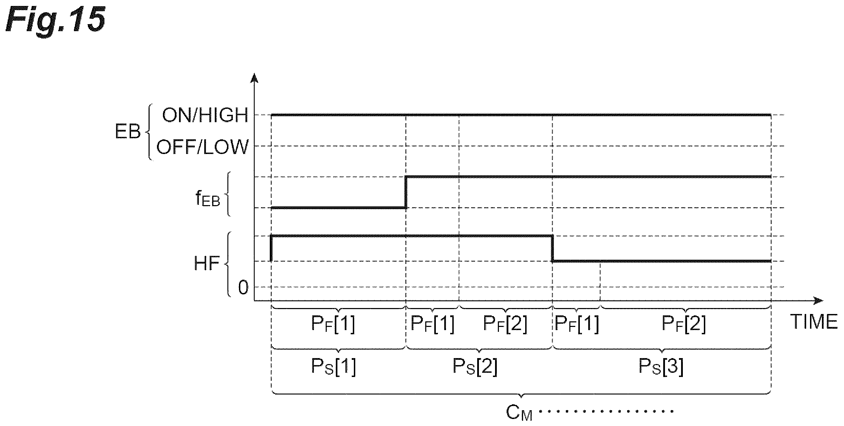

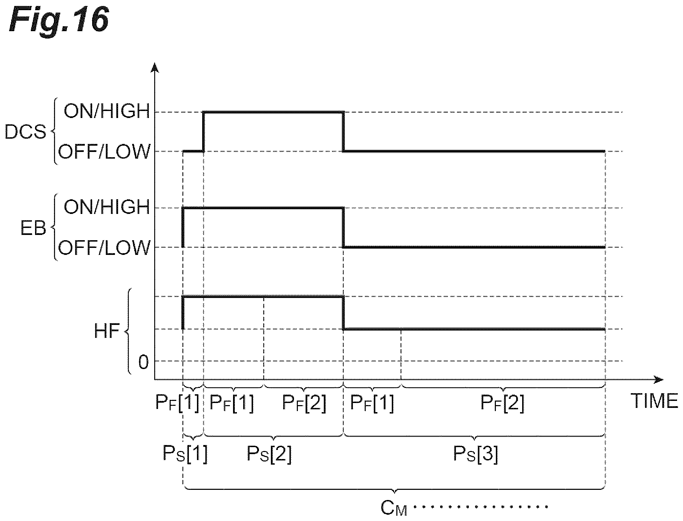

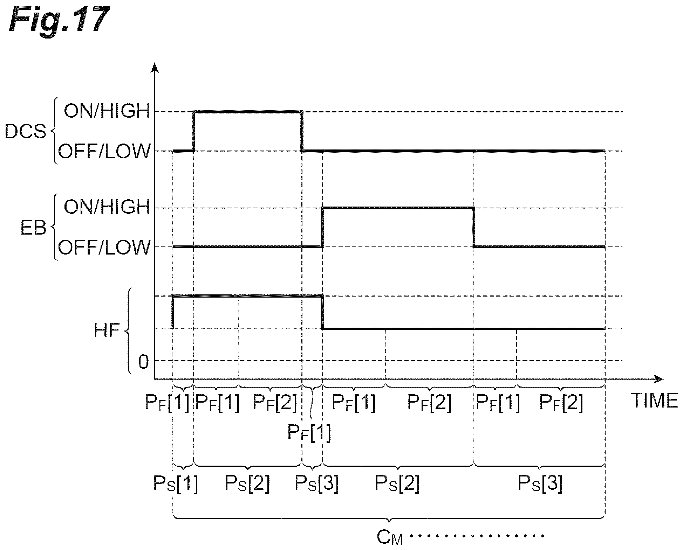

Hereinafter, reference is made to FIGS. 4 to 17 together with FIGS. 2 and 3. Each of FIGS. 4 to 17 is an example timing chart related to a power supply system according to one example embodiment. Each of FIGS. 4 to 17 illustrates the power level of the source radio frequency power HF and the level of the electric bias EB. In each of FIGS. 4 to 17, "ON" of the electric bias EB indicates that the electric bias EB is being supplied, and "OFF" of the electric bias EB indicates that the supply of the electric bias EB is stopped. In each of FIGS. 4 to 17, "HIGH" of the electric bias EB indicates that the electric bias EB having a level higher than the level indicated by "LOW" is being supplied. When the electric bias EB is the bias radio frequency power LF, the level of the electric bias EB is the power level of the bias radio frequency power LF. When the electric bias EB includes the voltage pulse VP, the electric bias EB has a higher level as the energy of ions attracted to the substrate W becomes higher. When the electric bias EB includes the voltage pulse VP, the level of the electric bias EB may be the absolute value of the voltage level in the negative direction of the voltage pulse VP with respect to a reference voltage (e.g., 0 V). In FIG. 14, a duty ratio $D_{VP}$ is further illustrated. The duty ratio $D_{VP}$ is the ratio of the time length during which the voltage pulse VP is supplied in the waveform cycle $C_W$ to the time length of the waveform cycle $C_W$. In FIG. 15, the bias frequency $f_{EB}$ is further illustrated. In FIGS. 16 and 17, the DC voltage DCS is further illustrated. In each of FIGS. 16 and 17, "ON" of the DC voltage DCS indicates that the DC voltage DCS is being supplied, and "OFF" of the DC voltage DCS indicates that the supply of the DC voltage DCS is stopped. In each of FIGS. 16 and 17, "HIGH" of the DC voltage DCS indicates that the DC voltage DCS having a level higher than the level indicated by "LOW" is being supplied. The level of the DC voltage DCS may be the absolute value of the voltage level in the negative direction of the DC voltage DCS with respect to its reference voltage level (e.g., 0 V).

As illustrated in FIGS. 4 to 17, the power level of the source radio frequency power HF from the radio frequency power supply 31 is modulated. The power level of the source radio frequency power HF from the radio frequency power supply 31 is specified by the power supply controller. The power supply controller is configured to periodically modulate the power level of the source radio frequency power HF in repetitions of the modulation cycle $C_M$, as illustrated in FIGS. 4 to 17. The power supply controller may be provided inside the radio frequency power supply 31, or may be provided outside the radio frequency power supply 31. The signal generator 31g may function as the power supply controller, or another device inside the radio frequency power supply 31 may function as the power supply controller. Alternatively, the controller 2 may function as the power supply controller.

Further, as illustrated in FIGS. 4 to 17, the power supply controller may be configured to periodically modulate the conditions of the electric bias EB in repetitions of the modulation cycle $C_M$. The power supply controller may periodically modulate the level of the electric bias EB in repetitions of the modulation cycle $C_M$. As illustrated in FIG. 14, the power supply controller may periodically modulate the duty ratio $D_{VP}$ in repetitions of the modulation cycle $C_M$. As illustrated in FIG. 15, the power supply controller may periodically modulate the bias frequency $f_{EB}$ in repetitions of the modulation cycle $C_M$. Furthermore, the power supply controller may periodically modulate the voltage level of the DC voltage DCS in repetitions of the modulation cycle $C_M$, as illustrated in FIGS. 16 and 17.

As illustrated in FIGS. 4 to 17, the modulation cycle $C_M$ includes a plurality of sub-periods $P_S$. In these figures, the numerical value in parentheses following $P_S$ represents the order of the sub-period $P_S$ within the modulation cycle $C_M$. As illustrated in FIGS. 4 to 17, the modulation cycle $C_M$ includes at least two sub-periods $P_S$ in which respective power levels of the source radio frequency power HF are set to levels greater than zero and different from each other. In the examples illustrated in FIGS. 4 to 15, each of the plurality of sub-periods $P_S$ is a period during which each of the power level of the source radio frequency power HF and the condition of the electric bias EB is maintained at a same setting. In the examples illustrated in each of FIGS. 16 and 17, each of the plurality of sub-periods $P_S$ is a period during which each of the power level of the source radio frequency power HF, the condition of the electric bias EB, and the output voltage level of the DC power supply 38 (i.e., the voltage level of the DC voltage DCS) is maintained at a same setting.

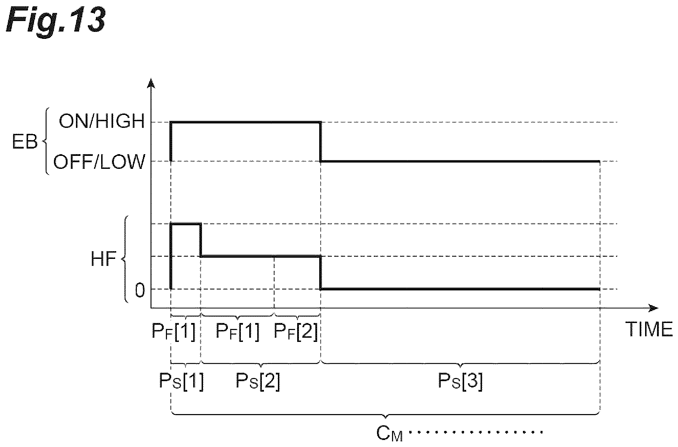

Each of the plurality of sub-periods $P_S$, when the source radio frequency power HF has a power level greater than 0 watts therein, includes a feedback period $P_F[1]$ (first feedback period) continuing from the start time thereof. As illustrated in FIGS. 4 to 12, each of the plurality of sub-periods $P_S$ may further include a feedback period $P_F[2]$ (second feedback period) as the remaining period following the feedback period $P_F[1]$. Alternatively, at least one of the plurality of sub-periods $P_S$ may include only the feedback period $P_F[1]$. That is, at least one of the plurality of sub-periods $P_S$ may coincide with the feedback period $P_F[1]$. In the example illustrated in FIG. 13, the sub-period $P_S[1]$ includes only the feedback period $P_F[1]$. Alternatively, each of the plurality of sub-periods $P_S$ may include only the feedback period $P_F[1]$. That is, each of the plurality of sub-periods $P_S$ may coincide with the feedback period $P_F[1]$.

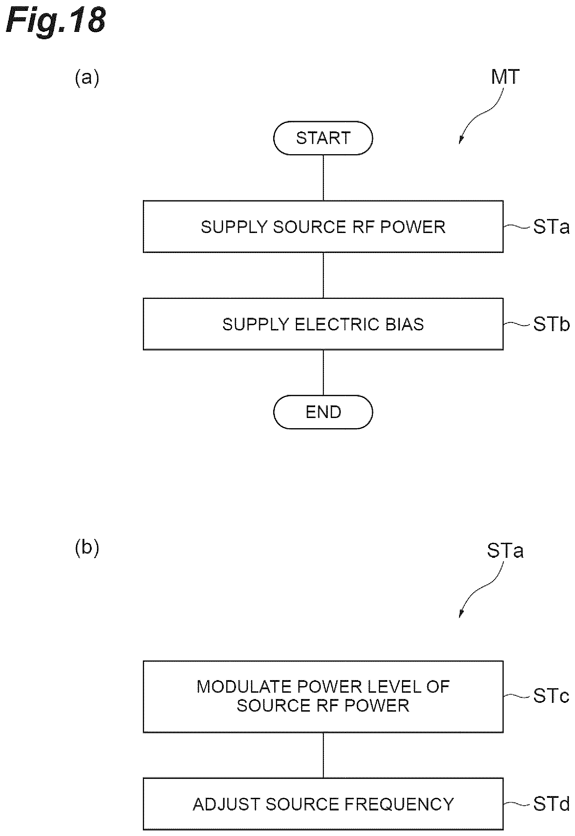

The radio frequency power supply 31 adjusts the source frequency f for each phase period $P_H$ within the modulation cycle $C_M$ in order to suppress reflection of the source radio frequency power HF from the load. The source frequency f is specified to the radio frequency power supply 31 by the power supply controller. Hereinafter, the adjustment of the source frequency f will be described with reference to FIG. 18(a) and FIG. 18(b) together with FIGS. 2 to 17. FIG. 18(a) is a flowchart of a control method according to one example embodiment, and FIG. 18(b) is a flowchart of step STa illustrated in FIG. 18(a). In the control method illustrated in FIG. 18(a) (hereinafter referred to as "method MT"), each part of the power supply system 30 is controlled by the power supply controller.

As illustrated in FIG. 18(a), the method MT includes step STa and step STb. In step STa, the source radio frequency power HF is supplied from the radio frequency power supply 31 to the radio frequency electrode to generate plasma in the chamber 10 of the plasma processing apparatus 1. Further, in step STb, the electric bias EB is supplied to the substrate support 11 (i.e., the bias electrode) repeatedly at a time interval of the waveform cycle $C_W$ to attract ions from the plasma to the substrate W on the substrate support 11.

As illustrated in FIG. 18(b), step STa includes step STc and step STd. In step STc, the power level of the source radio frequency power HF is periodically modulated in repetitions of the modulation cycle $C_M$, as in the examples of FIGS. 4 to 17. In step STb, the level of the electric bias EB may be periodically modulated in repetitions of the modulation cycle $C_M$. Further, as illustrated in FIGS. 16 and 17, the level of the DC voltage DCS may be periodically modulated in repetitions of the modulation cycle $C_M$.

In step STd, the source frequency f for each phase period $P_H$ within each modulation cycle $C_M$ is adjusted so as to suppress the degree of reflection of the source radio frequency power HF. The processing in step STd will be described in more detail below. In the following description, modulation cycle $C_M[y]$ represents the y-th modulation cycle $C_M$ in the repetitions of the modulation cycle $C_M$. Phase period $P_H[k]$ represents the k-th phase period within the modulation cycle $C_M$. Phase period $P_H[j]$ represents the j-th phase period within the waveform cycle $C_W$. Waveform cycle $C_W[m]$ represents the m-th waveform cycle $C_W$ in each of the feedback period $P_F[1]$ and the feedback period $P_F[2]$.

<Setting of Source Frequency in the 1st Modulation Cycle to the $Y_1$-th Modulation Cycle>

In the phase period $P_H[k]$ within each feedback period $P_F[1]$ in each of the modulation cycles $C_M[1]$ to $C_M[Y_1]$, a frequency prepared in advance for that phase period is used as the source frequency f. Alternatively, in the plurality of phase periods $P_H$ within the waveform cycle $C_W[m]$ in the feedback period $P_F[1]$ in each of the modulation cycles $C_M[1]$ to $C_M[Y_1]$, a plurality of frequencies included in a frequency set prepared in advance for that waveform cycle are used as the source frequency f, respectively. "$Y_1$" is an integer of 1 or more, and is, for example, 5.

In each of the plurality of phase periods $P_H$ within the waveform cycle $C_W[m]$ in the feedback period $P_F[2]$ in each of the modulation cycles $C_M[1]$ to $C_M[Y_1]$, a frequency determined by a second feedback described below may be used as the source frequency f. Alternatively, in the plurality of phase periods $P_H$ within each of the plurality of waveform cycles $C_W$ in the feedback period $P_F[2]$ in each of the modulation cycles $C_M[1]$ to $C_M[Y_1]$, the plurality of source frequencies f used in the plurality of phase periods $P_H$ within the last waveform cycle $C_W$ in the immediately preceding feedback period $P_F[1]$ may be used, respectively.

<Setting of Source Frequency in the $Y_2$-th Modulation Cycle and Subsequent Modulation Cycles>

In the phase period $P_H[k]$ within the feedback period $P_F[1]$ in each modulation cycle $C_M$ from the $Y_2$-th modulation cycle $C_M[Y_2]$ onward, a frequency determined by a first feedback described below is used as the source frequency f. Alternatively, in each of the plurality of phase periods $P_H$ within the waveform cycle $C_W[m]$ in the feedback period $P_F[1]$ in each modulation cycle $C_M$ from the modulation cycle $C_M[Y_2]$ onward, a frequency determined by the first feedback described below is used as the source frequency f.

In each of the plurality of phase periods $P_H$ within the waveform cycle $C_W[m]$ in the feedback period $P_F[2]$ in each modulation cycle $C_M$ from the modulation cycle $C_M[Y_2]$ onward, a frequency determined by the second feedback described below may be used as the source frequency f. Alternatively, in the plurality of phase periods $P_H$ within each of the plurality of waveform cycles $C_W$ in the feedback period $P_F[2]$ in each modulation cycle $C_M$ from the modulation cycle $C_M[Y_2]$ onward, the plurality of source frequencies f used in the plurality of phase periods $P_H$ within the last waveform cycle $C_W$ in the immediately preceding feedback period $P_F[1]$ may be used, respectively.

"$Y_2$" may be $Y_1+1$. Alternatively, a delay time may be provided between the modulation cycle $C_M[Y_1]$ and the modulation cycle $C_M[Y_2]$. The delay time may be on the order of several seconds. When a delay time is provided, the plurality of source frequencies f used in the plurality of phase periods $P_H$ in the modulation cycle $C_M[Y_1]$ may be used as the source frequencies for the plurality of phase periods $P_H$ in each modulation cycle $C_M$ immediately after the modulation cycle $C_M[Y_1]$ and up to immediately before the modulation cycle $C_M[Y_2]$, respectively.

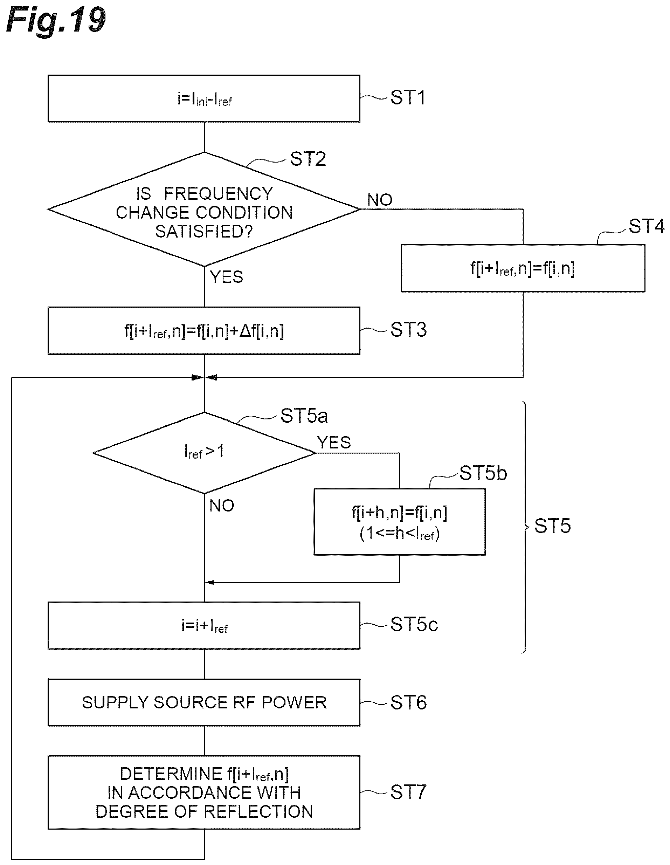

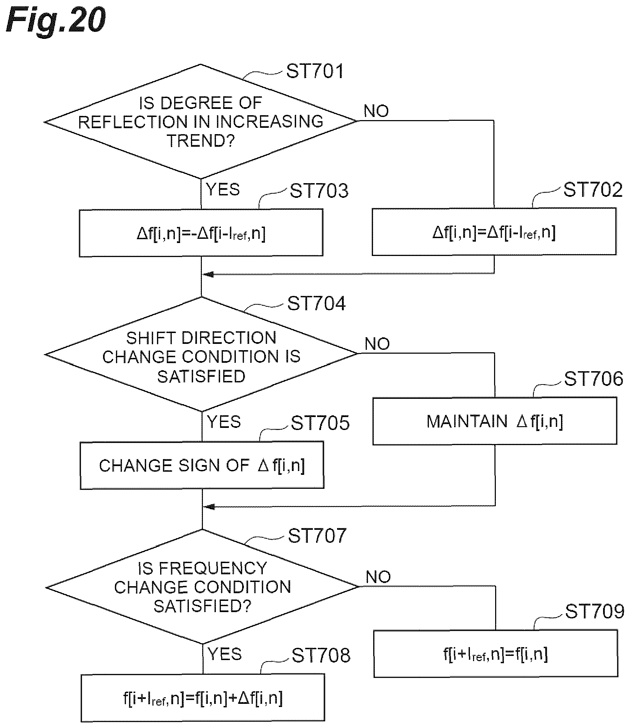

The first feedback and the second feedback will be described below with reference to FIGS. 19 and 20. FIG. 19 is a flowchart illustrating an example of processing in step STd illustrated in FIG. 18(b). FIG. 20 is a flowchart illustrating an example of processing in step ST7 illustrated in FIG. 19.

In the first feedback, the repetitions of the modulation cycle $C_M$, i.e., a plurality of modulation cycles $C_M$, form a cycle sequence $C_S$. In the second feedback, the plurality of waveform cycles $C_W$ within the feedback period $P_F[2]$ in the modulation cycle $C_M[y]$ and $I_{ref}$ waveform cycles $C_W$ immediately preceding that feedback period $P_F[2]$ form a cycle sequence $C_S$. In the first feedback, the source frequency f of the phase period $P_H[k]$ of the modulation cycle $C_M$ is determined so as to suppress the degree of reflection, based on a change in the source frequency f and a change in the degree of reflection of the source radio frequency power HF in the phase period $P_H[k]$ in the sequence of preceding modulation cycles $C_M$. In the second feedback, the source frequency f of the phase period $P_H[j]$ in the waveform cycle $C_W$ [m] within the feedback period $P_F[2]$ in the modulation cycle $C_M[y]$ is determined so as to suppress the degree of reflection, based on a change in the source frequency f and a change in the degree of reflection of the source radio frequency power HF in the phase period $P_H[j]$ in the sequence of waveform cycles $C_W$ preceding within the same feedback period $P_F[2]$. In each of the first feedback and the second feedback, the source frequency f is determined by the power supply controller.

Hereinafter, the phase period $P_H[k]$ in the sequence of modulation cycles $C_M$ in the first feedback and the phase period $P_H[j]$ in the sequence of waveform cycles $C_W$ in the second feedback are each referred to as a phase period $P_H[n]$ of the cycle sequence $C_S$. Further, each of the modulation cycle $C_M$ in the first feedback and the waveform cycle $C_W$ in the second feedback is referred to as a cycle $C_R$.

As illustrated in FIG. 19, step STd may include steps ST1 to ST7. Steps ST1 to ST7 are performed for each phase period $P_H$ within each cycle $C_R$ in the cycle sequence $C_S$.

In step ST1, the power supply controller sets i to $I_{ini}$-$I_{ref}$. "i" represents the order of the cycle $C_R$ included in the cycle sequence $C_S$. In the first feedback, "$I_{ini}$" is initially the above-mentioned "$Y_2$". In the first feedback, "$I_{ini}$-$I_{ref}$" represents the order of the cycle $C_R$ one before the $I_{ini}$-th cycle $C_R$ included in the cycle sequence $C_S$, and "$I_{ref}$" is 1. In the second feedback, "$I_{ini}$" is initially "1". In the second feedback, "$I_{ini}$-$I_{ref}$" represents the order of the cycle $C_R$ preceding, by $I_{ref}$ cycles, the $I_{ini}$-th cycle $C_R$ included in the cycle sequence $C_S$, and "$I_{ref}$" is an integer of 1 or more. In the second feedback, "$I_{ref}$" may be 1, may be 2, or may be an integer greater than 2. In the second feedback, when $I_{ref}$ is 2 or more, a relatively long processing time is secured as the processing time for determining the source frequency for each phase period $P_H$ in the second feedback.

In the subsequent step ST2, the power supply controller determines whether the degree of reflection $P_d[i,n]$ is large enough to satisfy the frequency change condition. $P_d[i,n]$ represents the degree of reflection of the phase period $P_H[n]$ within the i-th cycle $C_R[i]$ included in the cycle sequence $C_S$. In step ST2, the frequency change condition is satisfied when the degree of reflection $P_d[i,n]$ is greater than a threshold value. In step ST2, the frequency change condition may be satisfied when $P_d[i,n]$ is greater than a first threshold value $P_{th1}[n]$. The first threshold values $P_{th1}$ for each of the plurality of phase periods $P_H$ may be the same as or different from each other.

When it is determined in step ST2 that the frequency change condition is satisfied, the power supply controller sets the source frequency $f[i+I_{ref},n]$ in step ST3 according to equation (1).

$$f[i+I_{ref},n]=f[i,n]+\Delta f[i,n] \ldots (1)$$

Note that $f[i,n]$ represents the source frequency f of the phase period $P_H[n]$ within the i-th cycle $C_R[i]$ included in the cycle sequence $C_S$, and $\Delta f[i,n]$ is a shift value whose initial value is set in advance.

On the other hand, when it is determined in step ST2 that the frequency change condition is not satisfied, the power supply controller sets the source frequency $f[i+I_{ref},n]$ in step ST4 according to equation (2).

$$f[i+I_{ref},n]=f[i,n] \ldots (2)$$

Next, steps ST5 to ST7 are performed. Steps ST5 to ST7 are repeated until a termination instruction is issued. Step ST5 includes step ST5a, step ST5b, and step ST5c. In step ST5a, it is determined whether $I_{ref}$ is greater than 1. When $I_{ref}$ is 1, the processing proceeds to step ST5c. When $I_{ref}$ is greater than 1, the power supply controller sets $f[i+h,n]$ to $f[i,n]$ in step ST5b. The processing of step ST5b is performed while incrementing h from 1 to $I_{ref}$-1 by 1. Then, the processing proceeds to step ST5c.

In step ST5c, the power supply controller increments i by $1+I_{ref}$. In the subsequent step ST6, the power supply controller supplies the source radio frequency power HF having the source frequency $f[i,n]$ from the radio frequency power supply 31 in the phase period $P_H[n]$ within the cycle $C_R[i]$ in the cycle sequence $C_S$.

In the subsequent step ST7, the power supply controller determines the source frequency $f[i+I_{ref},n]$ for the phase period $P_H[n]$ within the subsequent cycle $C_R[i+I_{ref}]$ in the cycle sequence $C_S$, in accordance with the degree of reflection $P_d[i,n]$.

As illustrated in FIG. 20, step ST7 starts with step ST701. In step ST701, the power supply controller determines whether the degree of reflection $P_d[i,n]$ is in an increasing trend. In step ST701, the degree of reflection $P_d[i,n]$ may be determined to be in an increasing trend when $P_d[i,n]>P_d[i-I_{ref},n]$ is satisfied. Alternatively, the degree of reflection $P_d[i,n]$ may be determined to be in an increasing trend when the degree of reflection in the phase period $P_H[n]$ is in an increasing trend over X cycles $C_R$ until the i-th cycle $C_R[i]$ in the cycle sequence $C_S$. Here, "X" is an integer of 2 or more. The X cycles $C_R$ up to the i-th cycle $C_R[i]$ in the cycle sequence $C_S$ are represented by $C_R[i-x\times I_{ref}]$, where "x" is an integer from 0 to (X-1).

When it is determined in step ST701 that the degree of reflection $P_d[i,n]$ is not in an increasing trend, the power supply controller maintains the sign of the shift value $\Delta f[i,n]$ in step ST702. That is, the power supply controller sets the shift

value $\Delta f[i,n]$ in step ST702 according to equation (3).

$$\Delta f[i,n] = \Delta f[i-I_{ref},n] \ldots (3)$$

On the other hand, when it is determined in step ST701 that the degree of reflection $P_d[i,n]$ is in an increasing trend, the power supply controller changes the sign of the shift value $\Delta f[i,n]$ in step ST703. That is, the power supply controller sets the shift value $\Delta f[i,n]$ in step ST703 according to equation (4).

$$\Delta f[i,n] = -\Delta f[i-I_{ref},n] \ldots (4)$$

In the subsequent step ST704, the power supply controller determines whether the shift direction change condition is satisfied. The shift direction change condition is satisfied when, as a result of comparing each of the absolute value of the difference between the source frequency $f[i,n]$ and the source frequency $f[i,n-u]$ of the (n-u)-th phase period $P_H$[n-u] within the cycle $C_R[i]$ and the absolute value of the difference between the source frequency $f[i,n]$ and the source frequency $f[i,n+u]$ of the (n+u)-th phase period $P_H$[n+u] within the cycle $C_R[i]$ with a predetermined value, it is determined that the change in the source frequency is large, and both the source frequency $f[i,n-u]$ and the source frequency $f[i,n+u]$ are greater or smaller than the source frequency $f[i,n]$. For example, the shift direction change condition is satisfied when each of the absolute value of the difference between the source frequency $f[i,n]$ and the source frequency $f[i,n-u]$ and the absolute value of the difference between the source frequency $f[i,n]$ and the source frequency $f[i,n+u]$ is greater than a predetermined value, and both the source frequency $f[i,n-u]$ and the source frequency $f[i,n+u]$ are greater or smaller than the source frequency $f[i,n]$.

In step ST704, u may be 1, or may be a value greater than 1. Alternatively, in step ST704, the shift direction change condition may be satisfied when u is any value in the range from 1 to a value greater than 1.

When it is determined in step ST704 that the shift direction change condition is satisfied, the power supply controller changes the sign of the shift value $\Delta f[i,n]$ in step ST705. That is, the power supply controller sets the shift value $\Delta f[i,n]$ in step ST705 according to equation (5).

$$\Delta f[i,n] = |\Delta f[i-I_{ref},n]| * sign(f[i,n] - f[i,n-u]) \ldots (5)$$

Here, sign() is a function that returns the sign of the numerical value in the parentheses. Further, u is the value of u when the shift direction change condition is satisfied.

On the other hand, when it is determined in step ST704 that the shift direction change condition is not satisfied, the power supply controller maintains the sign of the shift value $\Delta f[i,n]$ in step ST706. That is, the power supply controller sets the shift value $\Delta f[i,n]$ in step ST706 according to equation (6).

$$\Delta f[i,n] = \Delta f[i,n] \ldots (6)$$

In the subsequent step ST707, the power supply controller determines whether the degree of reflection $P_d[i,n]$ of the source radio frequency power HF in the phase period $P_H$[n] within the cycle $C_R[i]$ in the cycle sequence $C_S$ is large enough to satisfy the frequency change condition. In step ST707, the frequency change condition is satisfied when the degree of reflection $P_d[i,n]$ of the source radio frequency power HF in the phase period $P_H$[n] within the cycle $C_R[i]$ in the cycle sequence $C_S$ is greater than a threshold value.

When it is determined in step ST707 that the frequency change condition is satisfied, the power supply controller sets the source frequency $f[i+I_{ref},n]$ for the phase period $P_H$[n] within the subsequent cycle $C_R[i+I_{ref}]$ in the cycle sequence $C_S$ in step ST708 according to equation (7).

$$f[i+I_{ref},n] = f[i,n] + \Delta f[i,n] \ldots (7)$$

On the other hand, when the frequency change condition is not satisfied in step ST707, the power supply controller sets the source frequency $f[i+I_{ref},n]$ in step ST709 according to equation (8).

$$f[i+I_{ref},n] = f[i,n] \ldots (8)$$

In one embodiment, when, as a result of the comparison in step ST707 between the degree of reflection in the phase period $P_H$[n] in any cycle $C_R$ within the cycle sequence $C_S$ and the first threshold value $P_{th1}$[n], it is determined that the degree of reflection is small, the frequency change condition may not be satisfied in step ST707 until it is determined in a subsequent step ST707 that the degree of reflection in the phase period $P_H[n]$ in the cycle $C_R$ is greater than a second threshold value $P_{th2}[n]$. The second threshold value $P_{th2}[n]$ is greater than or equal to the first threshold value $P_{th1}[n]$. The second threshold value $P_{th2}[n]$ may be greater than the first threshold value $P_{th1}[n]$. The second threshold values $P_{th2}[n]$ for each of the plurality of phase periods $P_H[n]$ may be the same as or different from each other.

Specifically, when it is determined in step ST707 that the degree of reflection in the phase period $P_H[n]$ in any cycle $C_R$ within the cycle sequence $C_S$ is less than or equal to the first threshold value $P_{th1}[n]$, the second threshold value $P_{th2}[n]$ may be used as the threshold value to be compared with the degree of reflection in the phase period $P_H[n]$ in subsequent step ST707. Then, when it is determined in step ST707 that the degree of reflection in the phase period $P_H[n]$ in any waveform cycle within the cycle sequence $C_S$ is greater than the second threshold value $P_{th2}[n]$, the first threshold value $P_{th1}[n]$ may be used as the threshold value to be compared with the degree of reflection in the phase period $P_H[n]$ in subsequent step ST707.

In the method MT, the reflection of the source radio frequency power HF is suppressed by adjusting the source frequency $f[i+I_{ref},n]$ in accordance with the degree of reflection $P_d[i,n]$. Further, when the shift direction change condition is satisfied, i.e., when a large fluctuation in the source frequency that may cause a large decrease or increase in the source frequency following a large increase or decrease in the source frequency within each cycle $C_R$ may occur, the sign of the shift value is changed. Therefore, according to the method MT, large fluctuations in the source frequency within the cycle $C_R$ are suppressed. Further, as described above, by using the first threshold value $P_{th1}$ and the second threshold value $P_{th2}$ in the determination of the frequency change condition, excessive changes in the source frequency are suppressed. Furthermore, when the method MT is repeated, high reproducibility of the temporal change in the source frequency can be achieved. Step ST7 illustrated in FIG. 20 may not include steps ST704 to ST706.

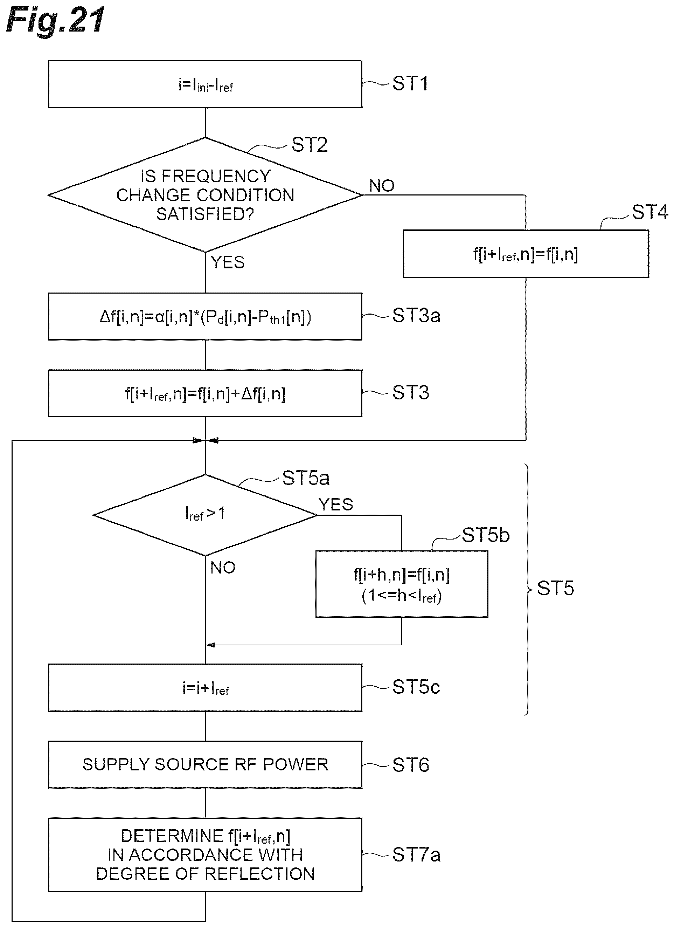

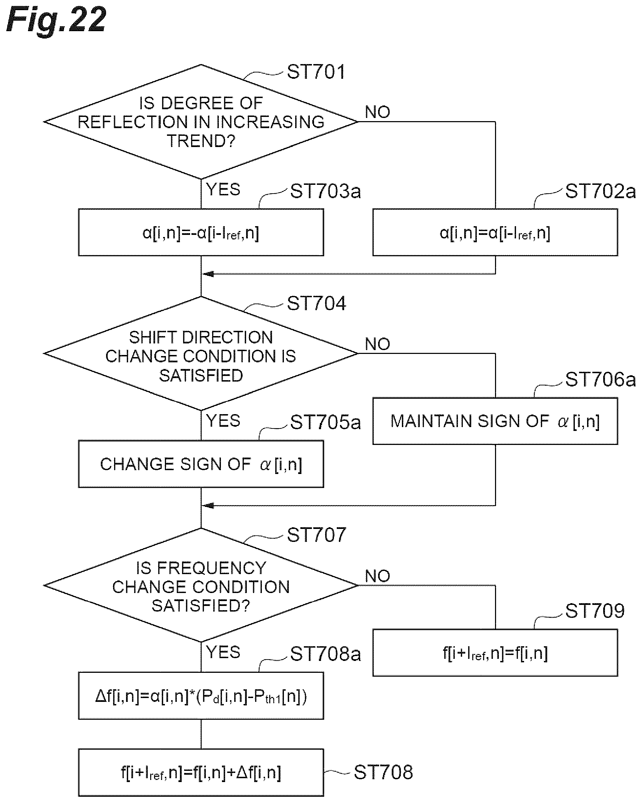

Another example of the processing in step STd will be described below with reference to FIGS. 21 and 22. FIG. 21 is a flowchart illustrating another example of processing in step STd illustrated in FIG. 18(b). FIG. 22 is a flowchart illustrating an example of processing in step ST7a illustrated in FIG. 21. The processing in step STd illustrated in FIGS. 21 and 22 will be described below from the perspective of differences from the processing illustrated in FIGS. 19 and 20. In the processing illustrated in FIGS. 21 and 22, the power supply controller sets the shift value $\Delta f[i,n]$ to a value corresponding to the magnitude of the degree of reflection $P_d[i,n]$.

Specifically, as illustrated in FIG. 21, the power supply controller sets the source frequency $f[i,n]$ and the coefficient $\alpha[i,n]$ in a step between step ST1 and step ST3. In the step between step ST1 and step ST3, the source frequency $f[i,n]$ and the coefficient $\alpha[i,n]$, i.e., the source frequency $f[1,n]$ and the coefficient $\alpha[1,n]$, are initially set to their respective pre-set values.

When it is determined in step ST2 that the frequency change condition is satisfied, the power supply controller sets the shift value $\Delta f[i,n]$ in step ST3a between step ST2 and step ST3 according to equation (9).

$$\Delta f[i,n] = \alpha[i,n] * (P_d[i,n] - P_{th1}[n]) \ \ldots \ (9)$$

Here, the coefficient $\alpha[1,n]$ is a pre-set value.

In step ST7a subsequent to step ST6, the power supply controller determines the source frequency $f[i+I_{ref},n]$ for the phase period $P_H[n]$ within the subsequent cycle $C_R[i+I_{ref}]$ in the cycle sequence $C_S$, in accordance with the degree of reflection $P_d[i,n]$.

As illustrated in FIG. 22, step ST7a starts with step ST701. When it is determined in step ST701 that the degree of reflection $P_d[i,n]$ is not in an increasing trend, the power supply controller maintains the sign of the coefficient $\alpha[i,n]$ in step ST702a. That is, the power supply controller sets the coefficient $\alpha[i,n]$ in step ST702a according to equation (10).

$$\alpha[i,n] = \alpha[i-I_{ref},n] \ \ldots \ (10)$$

On the other hand, when it is determined in step ST701 that the degree of reflection $P_d[i,n]$ is in an increasing trend, the power supply controller changes the sign of the coefficient $\alpha[i,n]$ in step ST703a. That is, the power supply controller sets the coefficient $\alpha[i,n]$ in step ST703a according to equation (11).

$$\alpha[i,n] = -\alpha[i-I_{ref},n] \ \ldots \ (11)$$

As illustrated in FIG. 22, when it is determined in step ST704 that the shift direction change condition is satisfied, the power supply controller changes the sign of the coefficient $\alpha[i,n]$ in step ST705a. That is, the power supply controller sets the coefficient $\alpha[i,n]$ in step ST705a according to equation (12).

$$\alpha[i,n]=|\alpha[i-I_{ref},n]|*sign(f[i,n]-f[i,n-u]) \ldots (12)$$

Here, u is the value of u when the shift direction change condition is satisfied.

On the other hand, when it is determined in step ST704 that the shift direction change condition is not satisfied, the power supply controller maintains the sign of the coefficient $\alpha[i,n]$ in step ST706a. That is, the power supply controller sets the coefficient $\alpha[i,n]$ in step ST706a according to equation (13).

$$\alpha[i,n]=\alpha[i,n] \ldots (13)$$

As illustrated in FIG. 22, when it is determined in step ST707 that the frequency change condition is satisfied, the power supply controller sets the shift value $\Delta f[i,n]$ in step ST708a between step ST707 and step ST708 according to equation (14).

$$\Delta f[i,n]=\alpha[i,n]*(P_d[i,n]-P_{th1}[n]) \ldots (14)$$

Also in the example of FIG. 22, when, as a result of the comparison in step ST707 between the degree of reflection in the phase period $P_H[n]$ in any cycle $C_R$ within the cycle sequence $C_S$ and the first threshold value $P_{th1}[n]$, it is determined that the degree of reflection is small, the frequency change condition may not be satisfied in step ST707 until it is determined in a subsequent step ST707 that the degree of reflection in the phase period $P_H[n]$ in the cycle $C_R$ is greater than a second threshold value $P_{th2}[n]$. The second threshold value $P_{th2}[n]$ is greater than or equal to the first threshold value $P_{th1}[n]$. The second threshold value $P_{th2}[n]$ may be greater than the first threshold value $P_{th1}[n]$. The second threshold values $P_{th2}[n]$ for each of the plurality of phase periods $P_H[n]$ may be the same as or different from each other.

Specifically, when it is determined in step ST707 that the degree of reflection in the phase period $P_H[n]$ in any cycle $C_R$ within the cycle sequence $C_S$ is less than or equal to the first threshold value $P_{th1}[n]$, the second threshold value $P_{th2}[n]$ may be used as the threshold value to be compared with the degree of reflection in the phase period $P_H[n]$ in subsequent step ST707. Then, when it is determined in step ST707 that the degree of reflection in the phase period $P_H[n]$ in any waveform cycle within the cycle sequence $C_S$ is greater than the second threshold value $P_{th2}[n]$, the first threshold value $P_{th1}[n]$ may be used as the threshold value to be compared with the degree of reflection in the phase period $P_H[n]$ in subsequent step ST707. Step ST7a illustrated in FIG. 22 may not include step ST704, step ST705a, and step ST706a.

The degree of reflection $P_d[i,n]$ will be described below. The degree of reflection $P_d[i,n]$ is obtained by acquiring a plurality of evaluation values respectively at a plurality of sample time points in the phase period $P_H[n]$ within the cycle CR[i] in the cycle sequence $C_S$. The plurality of evaluation values reflect the magnitude of reflection of the source radio frequency power HF respectively at the plurality of sample time points. The number of sample time points in each of the plurality of phase periods $P_H$ may be the same.

The degree of reflection $P_d[i,n]$ is a representative value of the evaluation values respectively at the plurality of sample time points in the phase period $P_H[n]$ within the cycle CR[i] in the cycle sequence $C_S$. The representative value is, for example, an average value of the plurality of evaluation values, a weighted average value of the plurality of evaluation values, or a maximum value of the plurality of evaluation values. Each of the plurality of evaluation values may be, as a measured value acquired by the sensors 35, 36, the power level Pr of the reflected wave, the reflectance (i.e., Pr/Pf), the magnitude of the difference between the impedance $Z_L$ and the characteristic impedance, or the reflection coefficient $\Gamma$. Each of the plurality of evaluation values may be the difference between the resistance value of the transmission system of the source radio frequency power HF as seen from the inlet of the matching unit 33 (i.e., the input of the matching unit 33 on the radio frequency power supply 31 side) or from the radio frequency power supply 31 and a predetermined resistance value (such as 50 $\Omega$). Alternatively, each of the plurality of evaluation values may be the difference between the phase difference between the voltage $V_S$ and the current $I_S$ at the transmission system of the source radio frequency power HF or at the inlet of the matching unit and a predetermined value (such as 90 degrees).

In one embodiment, the degree of reflection $P_d[i,n]$ is a weighted average value of the evaluation values respectively at the plurality of sample time points in the phase period $P_H[n]$ within the cycle CR[i] in the cycle sequence $C_S$. To obtain the weighted average value, the power supply controller calculates an average value of a plurality of values obtained by multiplying the plurality of evaluation values by a window function. The window function has weights that decrease in accordance with the time difference from the center of the phase period $P_H[n]$. As the window function, a triangular window, a Gaussian window, a Hanning window, a Hamming window, or the like is used. With the weighted average value using such a window function, it is possible to suppress variation in the calculated value of the degree of reflection $P_d[i,n]$ that may occur due to the phase of the source radio frequency power HF in each phase period $P_H$.

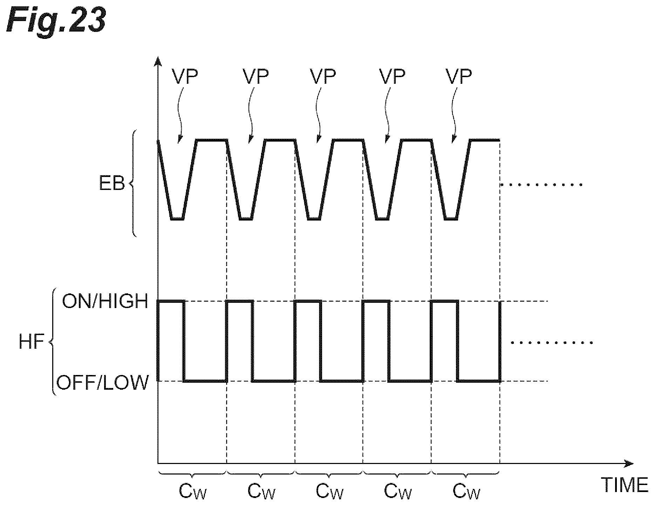

Here, reference is made to FIG. 23. FIG. 23 is a timing chart related to a power supply system according to one example embodiment. The radio frequency power supply 31 may supply the source radio frequency power HF continuously over the entire period of the waveform cycle $C_W$. Alternatively, the radio frequency power supply 31 may pulse the source radio frequency power HF within the waveform cycle $C_W$. That is, the radio frequency power supply 31 may supply pulses of the source radio frequency power HF within the waveform cycle $C_W$.

Although various example embodiments have been described above, various additions, omissions, substitutions, and changes may be made without being limited to the example embodiments described above. It is also possible to combine elements in different embodiments to form other embodiments.

Here, various example embodiments included in the present disclosure are described in [E1] to [E10] below.

[E1] A plasma processing apparatus including:

a chamber;
a substrate support disposed in the chamber; and
a power supply system,
wherein the power supply system includes:

a radio frequency power supply configured to supply source radio frequency power to generate plasma in the chamber;
a bias power supply configured to supply an electric bias to the substrate support repeatedly at a time interval of a waveform cycle to attract ions from the plasma to a substrate on the substrate support; and
a power supply controller,

the power supply controller is configured to periodically modulate a power level of the source radio frequency power in repetitions of a modulation cycle,
the modulation cycle includes a plurality of sub-periods, the plurality of sub-periods includes at least two sub-periods, respective power levels of the source radio frequency power in the at least two sub-periods being set to levels greater than zero and different from each other, each of the at least two sub-periods including a feedback period continuing from a start time thereof, and
the power supply controller is configured to adjust a source frequency of the source radio frequency power for a k-th phase period included in the feedback period within the modulation cycle, based on a change in the source frequency of the source radio frequency power and a change in a degree of reflection of the source radio frequency power in the k-th phase period in preceding repetitions of the modulation cycle, so as to suppress the degree of reflection of the source radio frequency power.

[E2] The plasma processing apparatus according to E1, wherein the power supply system is configured to maintain each of the power level of the source radio frequency power and a condition of the electric bias at a same setting in each of the plurality of sub-periods.

[E3] The plasma processing apparatus according to E1, wherein the power supply system further includes a DC power supply electrically connected to an upper electrode disposed above the substrate support, and
the power supply system is configured to maintain each of the power level of the source radio frequency power, a condition of the electric bias, and an output voltage level of the DC power supply at a same setting in each of the plurality of sub-periods.

[E4] The plasma processing apparatus according to E2 or E3, wherein the electric bias includes a voltage pulse periodically generated at a time interval of the waveform cycle, and
the condition of the electric bias includes at least one selected from a group consisting of a voltage level of the voltage pulse, a duty ratio of the voltage pulse, and a bias frequency that is a reciprocal of a time length of the waveform cycle.

[E5] The plasma processing apparatus according to E2 or E3, wherein the electric bias is a bias radio frequency power having a bias frequency that is a reciprocal of a time length of the waveform cycle, and
the condition of the electric bias includes at least one selected from a group consisting of a power level of the bias radio frequency power and the bias frequency.

[E6] The plasma processing apparatus according to any one of E1 to E5, wherein the feedback period is a first feedback period,

each of the at least two sub-periods includes a second feedback period following the first feedback period, and
the power supply controller is configured to control the radio frequency power supply so as to repeatedly use, in the second feedback period, a sequence of the source frequencies used in the waveform cycle immediately preceding the second feedback period.

[E7] The plasma processing apparatus according to any one of E1 to E5, wherein the feedback period is a first feedback period,

each of the at least two sub-periods includes a second feedback period following the first feedback period, and the power supply controller is configured to adjust the source frequency for a j-th phase period within each waveform cycle in the second feedback period of each of the at least two sub-periods, based on a change in the source frequency and a change in a degree of reflection of the source radio frequency power in the j-th phase period in preceding repetitions of the waveform cycle in each of the at least two sub-periods, so as to suppress the degree of reflection of the source radio frequency power.

[E8] The plasma processing apparatus according to any one of E1 to E5, wherein a length of each of the at least two sub-periods is equal to a length of the feedback period.

[E9] A power supply system including:

a radio frequency power supply configured to supply source radio frequency power to generate plasma in a chamber of a plasma processing apparatus;
a bias power supply configured to supply an electric bias to a substrate support repeatedly at a time interval of a waveform cycle to attract ions from the plasma to a substrate on the substrate support disposed in the chamber; and
a power supply controller,
wherein the power supply controller is configured to periodically modulate a power level of the source radio frequency power in repetitions of a modulation cycle,
the modulation cycle includes a plurality of sub-periods, the plurality of sub-periods includes at least two sub-periods, respective power levels of the source radio frequency power in the at least two sub-periods being set to levels greater than zero and different from each other, each of the at least two sub-periods including a feedback period continuing from a start time thereof, and
the power supply controller is configured to adjust a source frequency of the source radio frequency power for a k-th phase period included in the feedback period within the modulation cycle, based on a change in the source frequency of the source radio frequency power and a change in a degree of reflection of the source radio frequency power in the k-th phase period in preceding repetitions of the modulation cycle, so as to suppress the degree of reflection of the source radio frequency power.

[E10] A control method including:

(a) supplying source radio frequency power from a radio frequency power supply to generate plasma in a chamber of a plasma processing apparatus; and
(b) supplying an electric bias to a substrate support repeatedly at a time interval of a waveform cycle to attract ions from the plasma to a substrate on the substrate support disposed in the chamber,

wherein the (a) includes:

(c) periodically modulating a power level of the source radio frequency power in repetitions of a modulation cycle, the modulation cycle including a plurality of sub-periods, the plurality of sub-periods including at least two sub-periods, respective power levels of the source radio frequency power in the at least two sub-periods being set to levels greater than zero and different from each other, each of the at least two sub-periods including a feedback period continuing from a start time thereof; and
(d) adjusting a source frequency of the source radio frequency power for a k-th phase period included in the feedback period within the modulation cycle, wherein the source frequency for the k-th phase period within the modulation cycle is adjusted based on a change in the source frequency of the source radio frequency power and a change in a degree of reflection of the source radio frequency power in the k-th phase period in preceding repetitions of the modulation cycle, so as to suppress the degree of reflection of the source radio frequency power.

From the above description, it will be understood that various embodiments of the present disclosure have been described herein for purposes of illustration, and that various modifications may be made without departing from the scope and spirit of the present disclosure. Accordingly, the various embodiments disclosed herein are not intended to be limiting, and the true scope and spirit are indicated by the appended claims.

**Reference Signs List**

1: plasma processing apparatus, 10: chamber, 11: substrate support, 30: power supply system, 31: radio frequency power supply, 32: bias power supply.

Claims

1. A plasma processing apparatus comprising:

   a chamber;
   a substrate support disposed in the chamber; and
   a power supply system,
   wherein the power supply system includes:

   a radio frequency power supply configured to supply radio frequency power to generate plasma in the chamber;
   a bias power supply configured to supply an electric bias to the substrate support repeatedly at a time interval of a waveform cycle to attract ions from the plasma to a substrate on the substrate support; and
   a power supply controller,

   the power supply controller is configured to periodically modulate a power level of the radio frequency power in repetitions of a modulation cycle,
   the modulation cycle includes a plurality of sub-periods, the plurality of sub-periods includes at least two sub-periods, respective power levels of the radio frequency power in the at least two sub-periods being set to levels greater than zero and different from each other, each of the at least two sub-periods including a feedback period continuing from a start time thereof, and
   the power supply controller is configured to adjust a frequency of the radio frequency power for a k-th phase period included in the feedback period within the modulation cycle, based on a change in the frequency of the radio frequency power and a change in a degree of reflection of the radio frequency power in the k-th phase period in preceding repetitions of the modulation cycle, so as to suppress the degree of reflection of the radio frequency power.

2. The plasma processing apparatus according to claim 1, wherein the power supply system is configured to maintain each of the power level of the radio frequency power and a condition of the electric bias at a same setting in each of the plurality of sub-periods.

3. The plasma processing apparatus according to claim 1, wherein the power supply system further includes a DC power supply electrically connected to an upper electrode disposed above the substrate support, and the power supply system is configured to maintain each of the power level of the radio frequency power, a condition of the electric bias, and an output voltage level of the DC power supply at a same setting in each of the plurality of sub-periods.

4. The plasma processing apparatus according to claim 2 or 3, wherein the electric bias includes a voltage pulse periodically generated at a time interval of the waveform cycle, and
   the condition of the electric bias includes at least one selected from a group consisting of a voltage level of the voltage pulse, a duty ratio of the voltage pulse, and a bias frequency that is a reciprocal of a time length of the waveform cycle.

5. The plasma processing apparatus according to claim 2 or 3, wherein the electric bias is a bias radio frequency power having a bias frequency that is a reciprocal of a time length of the waveform cycle, and
   the condition of the electric bias includes at least one selected from a group consisting of a power level of the bias radio frequency power and the bias frequency.

6. The plasma processing apparatus according to any one of claims 1 to 3, wherein the feedback period is a first feedback period,

   each of the at least two sub-periods includes a second feedback period following the first feedback period, and
   the power supply controller is configured to control the radio frequency power supply so as to repeatedly use, in the second feedback period, a sequence of frequencies of the radio frequency power used in the waveform cycle immediately preceding the second feedback period.

7. The plasma processing apparatus according to any one of claims 1 to 3, wherein the feedback period is a first feedback period,

   each of the at least two sub-periods includes a second feedback period following the first feedback period, and

the power supply controller is configured to adjust the frequency of the radio frequency power for a j-th phase period within each waveform cycle in the second feedback period of each of the at least two sub-periods, based on a change in the frequency of the radio frequency power and a change in a degree of reflection of the radio frequency power in the j-th phase period in preceding repetitions of the waveform cycle in each of the at least two sub-periods, so as to suppress the degree of reflection of the radio frequency power.

8. The plasma processing apparatus according to any one of claims 1 to 3, wherein a length of each of the at least two sub-periods is equal to a length of the feedback period.

9. A power supply system comprising:

a radio frequency power supply configured to supply radio frequency power to generate plasma in a chamber of a plasma processing apparatus;
a bias power supply configured to supply an electric bias to a substrate support repeatedly at a time interval of a waveform cycle to attract ions from the plasma to a substrate on the substrate support disposed in the chamber; and
a power supply controller,
wherein the power supply controller is configured to periodically modulate a power level of the radio frequency power in repetitions of a modulation cycle,
the modulation cycle includes a plurality of sub-periods, the plurality of sub-periods includes at least two sub-periods, respective power levels of the radio frequency power in the at least two sub-periods being set to levels greater than zero and different from each other, each of the at least two sub-periods including a feedback period continuing from a start time thereof, and
the power supply controller is configured to adjust a frequency of the radio frequency power for a k-th phase period included in the feedback period within the modulation cycle, based on a change in the frequency of the radio frequency power and a change in a degree of reflection of the radio frequency power in the k-th phase period in preceding repetitions of the modulation cycle, so as to suppress the degree of reflection of the radio frequency power.

10. A control method comprising:

(a) supplying radio frequency power from a radio frequency power supply to generate plasma in a chamber of a plasma processing apparatus; and
(b) supplying an electric bias to a substrate support repeatedly at a time interval of a waveform cycle to attract ions from the plasma to a substrate on the substrate support disposed in the chamber,

wherein the (a) includes:

(c) periodically modulating a power level of the radio frequency power in repetitions of a modulation cycle, the modulation cycle including a plurality of sub-periods, the plurality of sub-periods including at least two sub-periods, respective power levels of the radio frequency power in the at least two sub-periods being set to levels greater than zero and different from each other, each of the at least two sub-periods including a feedback period continuing from a start time thereof; and
(d) adjusting a frequency of the radio frequency power for a k-th phase period included in the feedback period within the modulation cycle, wherein the frequency of the radio frequency power for the k-th phase period within the modulation cycle is adjusted based on a change in the frequency of the radio frequency power and a change in a degree of reflection of the radio frequency power in the k-th phase period in preceding repetitions of the modulation cycle, so as to suppress the degree of reflection of the radio frequency power.

# Fig.1

PLASMA PROCESSING APPARATUS 1

| 10 |
|---|
| 11 |
| 12 |

CONTROLLER 2

2a

| 2a1 | 2a2 | 2a3 |

*Fig.2*

## Fig.3

*Fig.4*

*Fig.5*

**Fig.6**

*Fig.7*

# Fig.8

## Fig.9

## Fig.10

## Fig.11

*Fig.12*

## Fig.13

*Fig.14*

EP 4 780 143 A1

EP 4 780 143 A1

**Fig.15**

## Fig.16

## Fig.17

# *Fig.18*

(a)

MT

```
        ┌──────────┐
        │  START   │
        └──────────┘
             │
┌────────────────────────────┐
│   SUPPLY SOURCE RF POWER    │──STa
└────────────────────────────┘
             │
┌────────────────────────────┐
│   SUPPLY ELECTRIC BIAS      │──STb
└────────────────────────────┘
             │
        ┌──────────┐
        │   END    │
        └──────────┘
```

(b)

STa

```
┌────────────────────────────┐
│   MODULATE POWER LEVEL OF   │──STc
│      SOURCE RF POWER        │
└────────────────────────────┘
             │
┌────────────────────────────┐
│   ADJUST SOURCE FREQUENCY   │──STd
└────────────────────────────┘
```

# Fig.19

$i = I_{ini} - I_{ref}$ — ST1

ST2
IS FREQUENCY CHANGE CONDITION SATISFIED?

NO → ST4
$f[i+I_{ref},n]=f[i,n]$

YES

$f[i+I_{ref},n]=f[i,n]+\Delta f[i,n]$ — ST3

ST5a
$I_{ref} > 1$

YES → ST5b
$f[i+h,n]=f[i,n]$
$(1<=h<I_{ref})$

NO

} ST5

$i=i+I_{ref}$ — ST5c

SUPPLY SOURCE RF POWER — ST6

DETERMINE $f[i+I_{ref},n]$ IN ACCORDANCE WITH DEGREE OF REFLECTION — ST7

## Fig.20

```
                    ST701
        ┌─────────────────────┐
        │  IS DEGREE OF       │    NO
        │ REFLECTION IN       ├──────────────────┐
        │ INCREASING TREND?   │                  │
        └──────────┬──────────┘                  │
              YES │    ST703              ST702  │
        ┌──────────┴──────────┐   ┌───────────────┴──────┐
        │ Δf[i,n]=-Δf[i-Iref,n]│   │ Δf[i,n]=Δf[i-Iref,n] │
        └──────────┬──────────┘   └───────────┬──────────┘
                   │◄─────────────────────────┘
                    ST704
        ┌─────────────────────┐
        │  SHIFT DIRECTION    │    NO
        │ CHANGE CONDITION IS ├──────────────────┐
        │ SATISFIED           │                  │
        └──────────┬──────────┘             ST706│
              YES │    ST705      ┌───────────────┴──────┐
        ┌──────────┴──────────┐   │   MAINTAIN Δf[i,n]    │
        │ CHANGE SIGN OF Δf[i,n]│  └───────────┬──────────┘
        └──────────┬──────────┘                │
                   │◄─────────────────────────┘
                    ST707
        ┌─────────────────────┐
        │  IS FREQUENCY       │    NO
        │ CHANGE CONDITION    ├──────────────────┐
        │ SATISFIED?          │             ST709│
        └──────────┬──────────┘   ┌───────────────┴──────┐
              YES │    ST708      │  f[i+Iref,n]=f[i,n]   │
        ┌──────────┴──────────┐   └──────────────────────┘
        │f[i+Iref,n]=f[i,n]+Δf[i,n]│
        └─────────────────────┘
```

**ST701** IS DEGREE OF REFLECTION IN INCREASING TREND?

NO → **ST702** $\Delta f[i,n]=\Delta f[i-I_{ref},n]$

YES → **ST703** $\Delta f[i,n]=-\Delta f[i-I_{ref},n]$

**ST704** SHIFT DIRECTION CHANGE CONDITION IS SATISFIED

NO → **ST706** MAINTAIN $\Delta f[i,n]$

YES → **ST705** CHANGE SIGN OF $\Delta f[i,n]$

**ST707** IS FREQUENCY CHANGE CONDITION SATISFIED?

NO → **ST709** $f[i+I_{ref},n]=f[i,n]$

YES → **ST708** $f[i+I_{ref},n]=f[i,n]+\Delta f[i,n]$

## Fig.21

ST1 — $i=I_{ini}-I_{ref}$

ST2 — IS FREQUENCY CHANGE CONDITION SATISFIED?

NO → ST4 — $f[i+I_{ref},n]=f[i,n]$

YES

ST3a — $\Delta f[i,n]=\alpha[i,n]*(P_d[i,n]-P_{th1}[n])$

ST3 — $f[i+I_{ref},n]=f[i,n]+\Delta f[i,n]$

ST5a — $I_{ref}>1$

YES → ST5b — $f[i+h,n]=f[i,n]$ $(1<=h<I_{ref})$

NO

ST5c — $i=i+I_{ref}$

ST5

ST6 — SUPPLY SOURCE RF POWER

ST7a — DETERMINE $f[i+I_{ref},n]$ IN ACCORDANCE WITH DEGREE OF REFLECTION

# Fig.22

```
                    ST701
              IS DEGREE OF
         REFLECTION IN INCREASING          NO
              TREND?
```

YES ── ST703a                                    ST702a

| $\alpha[i,n]=-\alpha[i-I_{ref},n]$ | | $\alpha[i,n]=\alpha[i-I_{ref},n]$ |

```
                    ST704
            SHIFT DIRECTION
         CHANGE CONDITION IS            NO
              SATISFIED
```

                                                 ST706a

YES ── ST705a    | MAINTAIN SIGN OF $\alpha[i,n]$ |

| CHANGE SIGN OF $\alpha[i,n]$ |

```
                    ST707
             IS FREQUENCY
          CHANGE CONDITION             NO
             SATISFIED?
```

                                                 ST709

YES ── ST708a         | $f[i+I_{ref},n]=f[i,n]$ |

| $\Delta f[i,n]=\alpha[i,n]*(P_d[i,n]-P_{th1}[n])$ |

| $f[i+I_{ref},n]=f[i,n]+\Delta f[i,n]$ | ── ST708

## Fig.23

## INTERNATIONAL SEARCH REPORT

| International application No. |
|---|
| **PCT/JP2024/039311** |

**A. CLASSIFICATION OF SUBJECT MATTER**

***H05H 1/46***(2006.01)i
FI: H05H1/46 R

According to International Patent Classification (IPC) or to both national classification and IPC

**B. FIELDS SEARCHED**

Minimum documentation searched (classification system followed by classification symbols)

H05H1/00-1/54

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2017-073247 A (TOKYO ELECTRON LIMITED) 13 April 2017 (2017-04-13) abstract, fig. 18 | 1-10 |
| A | JP 2021-106354 A (DAIHEN CORP.) 26 July 2021 (2021-07-26) abstract, fig. 1 | 1-10 |
| A | JP 2022-071824 A (TOKYO ELECTRON LIMITED) 16 May 2022 (2022-05-16) paragraphs [0067]-[0085], fig. 7-9 | 1-10 |
| A | US 2021/0057188 A1 (ADVANCED MICRO-FABRICATION EQUIPMENT INC.) 25 February 2021 (2021-02-25) abstract, fig. 4 | 1-10 |

☐ Further documents are listed in the continuation of Box C.　　☑ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| **11 December 2024** | **24 December 2024** |

| Name and mailing address of the ISA/JP | Authorized officer |
|---|---|
| **Japan Patent Office (ISA/JP)** 3-4-3 Kasumigaseki, Chiyoda-ku, Tokyo 100-8915 Japan | |
| | Telephone No. |

Form PCT/ISA/210 (second sheet) (July 2022)

**INTERNATIONAL SEARCH REPORT**
Information on patent family members

International application No.

**PCT/JP2024/039311**

| Patent document cited in search report | | | Publication date (day/month/year) | Patent family member(s) | | | Publication date (day/month/year) |
|---|---|---|---|---|---|---|---|
| JP | 2017-073247 | A | 13 April 2017 | US abstract, fig. 18 | 2017/0099723 | A1 | |
| | | | | KR | 10-2017-0041142 | A | |
| | | | | CN | 106941067 | A | |
| | | | | TW | 201719751 | A | |
| | | | | SG | 10201608348S | A | |
| JP | 2021-106354 | A | 26 July 2021 | US abstract, fig. 1 | 2021/0202211 | A1 | |
| | | | | KR | 10-2021-0084273 | A | |
| JP | 2022-071824 | A | 16 May 2022 | US paragraphs [0091]-[0112], fig. 7-9 | 2022/0130643 | A1 | |
| | | | | KR | 10-2022-0056805 | A | |
| | | | | CN | 114496697 | A | |
| | | | | TW | 202220500 | A | |
| US | 2021/0057188 | A1 | 25 February 2021 | CN abstract, fig. 4 | 110299279 | A | |
| | | | | TW | 202110287 | A | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009246091 A